# EUROPEAN PATENT APPLICATION

(11) **EP 2 665 210 A2**
(43) Date of publication of application: **20.11.2013**
(21) Application number: 12008559.2
(22) Date of filing: 21.12.2012
(51) Int. Cl.: H04J 3/06

(54) **Time Base Management System**

(30) Priority: 15.05.2012 US 201213471923
(71) Applicant: Broadcom Corporation, Irvine, CA 92617 (US)
(72) Inventor: Diab, Wael, San Francisco, CA 94109 (US); Walley, John, Ladera Ranch, CA 92694 (US)
(74) Representative: Jehle, Volker Armin

(57) **Abstract**

A time base management system facilitates early analysis, detection, and status messages (e.g., early warnings) concerning the operation of time bases in a device. In addition, the time base management system may adapt the time bases in the device according to the anticipated, selected, or actual operating conditions of the device. As one example, if the time base management system knows that a cell phone will switch to a high data rate (e.g., 4G or LTE) operation mode, the time base management system may configure a time base in the cell phone to operate with increased precision or accuracy, or otherwise meet any applicable time base operational profile for high data rate operation.

## Description

### 1. Technical Field

This disclosure relates to time bases such as semiconductor and crystal oscillators, used for many different purposes, such as driving or clocking data between communication interfaces.

### 2. Background

Rapid advances in electronics, driven by immense customer demand, have brought network switches and routers, smart phones, Global Positioning Systems (GPS), and a vast array of other electronic devices into global use. Network devices, for example, are commonly used not only in the home, but also to route staggering amounts of network traffic across business infrastructure and around the world. As another example, some estimates put the number of wireless subscriber connections in use around the world at nearly 80% of the world's population, and in the United States, Italy, and the UK (just as three examples), estimates show that there are more mobile phones in use than there are people.

Virtually all electronic devices include one or more time bases that can be of critical importance for proper operation of the device. Time bases do not always operate correctly, however, and do not always operate in a manner adapted to the current operational characteristics of the device. Furthermore, time bases can fail or begin to fail in complex ways that are extremely difficult and costly to troubleshoot, and for such problems there is typically no early warning.

Furthermore, time bases serve a large variety of roles. While some time bases may provide time information as such, other time bases are used in different manners that are equally important. In the context of an Ethernet network switch, for example, a time base may produce the frequency reference that drives serialized data between communication interfaces. When the receiver uses the same frequency, the receiver can recover clocking information from the serialized data stream. However, if frequency and phase drift (as examples) cause too much variation at the sender, then the receiver may not be able to recover the clocking information and correctly receive the data.

### Brief Summary Of The Invention

According to an aspect, a method comprises:
interfacing to a silicon time base through a management interface; and
managing the silicon time base through the management interface.

Advantageously, managing comprises:
reconfiguring the silicon time base.

Advantageously, managing comprises:
executing a test of the silicon time base.

Advantageously, managing comprises:
adapting the silicon time base according to a selected quality profile.

Advantageously, managing comprises:
adapting the silicon time base according to a selected energy consumption profile.

Advantageously, managing comprises:
adapting the silicon time base according to a selected oscillator output profile.

Advantageously, reconfiguring comprises:
reconfiguring a first part of the silicon time base to facilitate a test on a second part of the silicon time base.

Advantageously, managing comprises:
obtaining an operational characteristic of the silicon time base.

Advantageously, the operational characteristic comprises a voltage, current, or temperature characteristic of the time base, or any combination thereof.

Advantageously, the operational characteristic comprises a frequency characteristic of the time base.

According to an aspect, a system comprises:
a time base;
a management interface in communication with the time base; and
a time base manager configured to execute a management action on the time base through the time base management interface.

Advantageously, the management action comprises:
reconfiguring the time base.

Advantageously, the management action comprises:
executing a test of the time base.

Advantageously, the management action comprises:
adapting the time base to meet a selected quality profile.

Advantageously, the management action comprises:
adapting the silicon time base to meet a selected energy consumption profile.

Advantageously, the management action comprises:
adapting the time base to meet a selected oscillator output profile.

Advantageously, the management action comprises:
reconfiguring a first part of the time base to facilitate a test on a second part of the time base.

Advantageously, the management action comprises:
obtaining an operational characteristic of the silicon time base.

Advantageously, the operational characteristic comprises a voltage, current, or temperature characteristic of the time base, or any combination thereof.

Advantageously, the management action comprises:
receiving a management instruction from an external system; and
taking a responsive action on the time base according to the management instruction.

### BRIEF DESCRIPTION OF THE DRAWINGS

The innovation may be better understood with reference to the following drawings and description. In the figures, like reference numerals designate corresponding parts throughout the different views.

Figure 1 shows an example device that includes time base management logic.

Figure 2 is another example of a device that includes time base management logic.

Figure 3 shows additional examples of devices that may include time base management logic.

Figure 4 shows time base management logic for obtaining operational data concerning time bases and taking actions based on analysis of the operational data.

Figure 5 shows time base management logic for adapting a time base to device operational conditions.

Figure 6 shows a distributed architecture for managing time bases.

### DETAILED DESCRIPTION

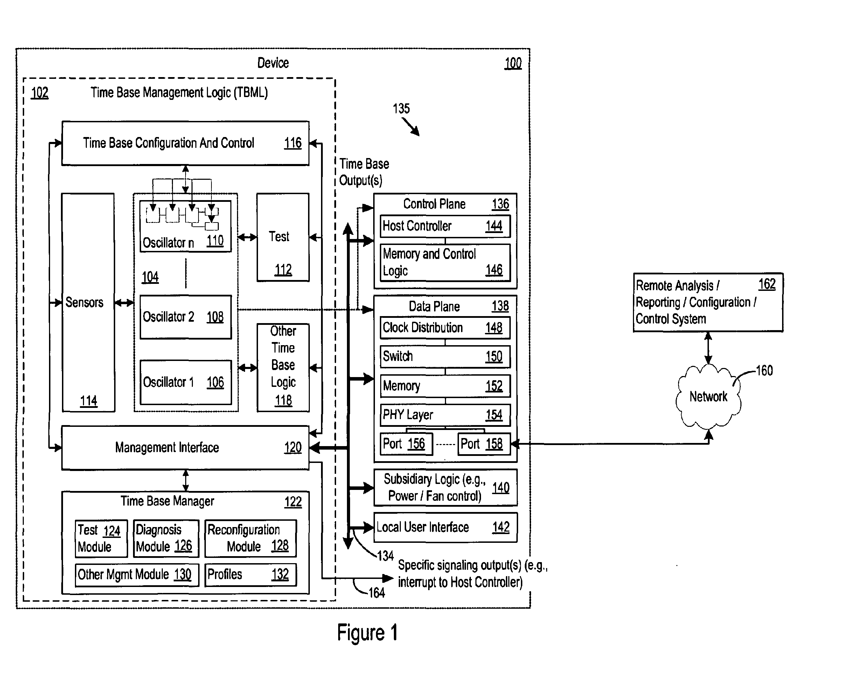

Figure 1 shows an example device 100 that includes time base management logic (TBML) 102. In the example shown in Figure 1, the TBML 102 manages a set of time bases 104, any of which may provide one or more time references for any part of the device 100. The time bases may be MEMS, silicon, or semiconductor oscillators (e.g., oscillators such as those available from eoSemi (TM) Ltd.), crystal oscillators, or other types of oscillators. The implementation of any particular time base may determine, in part, to what degree and how the time base may be managed, as will be described in more detail below. Three time bases are labeled in Figure 1 for the purposes of illustration: oscillator 1 106, oscillator 2 108, and oscillator 'n' 110. The set of time bases 104 may include any number of time bases.

In communication with the set of time bases 104 is management support logic. Four examples of management support logic are shown in Figure 1: the test logic 112, the sensors 114, the time base configuration and control logic 116, and the other time base logic 118. Additional, less, or different management support logic may be provided in other implementations. The test logic 112 may include logic that applies test signals, conditions, procedures, parameters, or other physical or electrical test inputs to any of the time bases. As examples, the test logic 112 may generate test inputs that include voltages, currents, waveforms of arbitrary shape and frequency, mechanical stress, heat stress, oscillator component enable or disable signals, or other test inputs. The sensors 114 may include logic that measure, sample, or otherwise sense operating characteristics of any of the time bases or components of the time bases. As examples, the sensors 114 may include voltage sensors, current sensors, heat sensors, mechanical stress sensors, frequency sensors, or other types of sensors. The time base configuration and control logic 116 may apply configuration and control inputs to any of the time bases or any components of the time bases. As examples, the time base configuration and control logic 116 may apply control inputs that enable or disable a time base as a whole, that enable or disable any component part of a time base, that change connections in the time base to reconfigure the time base to generate additional or fewer clock outputs, to reconfigure the time base to use some of its components to test other of its components, to increase or decreased the time base frequency or amplitude output, to increase or decrease time base power consumption, or that increase or decrease output quality (e.g., by increasing or decreasing clock stability, frequency accuracy, or other quality parameters, such as signal-to-noise ratio (SNR)). The other time base logic 118 may be provided to generate other control, configuration, test, or other management signals for the set of time bases 104 that are not necessarily covered by the test logic 112, sensors 114, and time base configuration and control logic 116. For example the other time base logic 118 may include a state machine, a counter, a filter (e.g., a filter that adjusts signal-to-noise ratio), a multiplier (e.g., a multiplier configured to multiply up the frequency of a base clock signal generated by a time base), or a sequencer (e.g., a microsequencer) that interacts with the time bases in any desired way.

The control inputs for the time base configuration and control logic 116 may be regulated by a state machine or a counter that may be based on output from the test logic 112, the sensors 114, or the other time base logic 118. The control inputs may relate to operational conditions of a time base, such as a time base or components of the time base operating outside of its triode mode or linear region. Also, the control inputs for the time base configuration and control logic 116 may include or be based on real-time or historical operational data (e.g., real-time or historical SNR) regarding the TBML 102, the device 100, or other devices in communication with the device 100 (e.g., devices of network 160). Such operational data may facilitate time base control (e.g., time base diagnosis or calibration) in a proactive rather than reactive manner by the TBML 102, the device 100, or other devices in communication with the device 100. For example, by being aware of operational conditions internal and external to the TBML 102 or the device 100, the time base configuration and control logic 116 can calibrate a time base with respect to such conditions that either currently exist or are predicted to exist. Self-calibration of any time base (e.g., calibration upon startup of the device 100) is just one example of the control that may be exercised by the TBML 102.

The TBML 102 also includes the management interface 120 and the time base manager 122. The management interface 120 provides a signal connection interface between the time base manager 122 and the management support logic. To that end, the management interface 120 may include buffers, amplifiers, line drivers, messaging interfaces or other analog or digital logic to communicate with the management support logic and the time base manager 122.

The time base manager 122 provides management control over the set of time bases 104. The time base manager 122 may include any desired management logic in that regard. Figure 1 shows several examples: a test module 124, a diagnosis module 126, a reconfiguration model 128, and an other management module 130. The time base manager 122 may operate with respect to management profiles 132, as will be discussed further below.

The test module 124 may include logic that applies test inputs such as those described above to the time bases. The diagnosis module 126 may include logic that receives operational characteristics of the time bases (e.g., from the sensors 114) and analyzes the operational characteristics to determine how well a time base is performing. The reconfiguration module 128 may include logic that selectively adjusts connections within or among the time bases in order to change any desired operational characteristic of the time bases. The other management module 130 may implement any other interactions that the time base manager 122 desires with the set of time bases 104. Specific examples of time base management are given below.

The management interface 120 communicates with other system logic over the communication bus 134. The communication bus 134 may be implemented in many different ways. As examples, the communication bus 134 may be a serial bus (e.g., an inter-integrated circuit (I²C) bus, serial two wire or three wire interface (or other serial interface)), parallel bus, peripheral component interconnect (PCI) bus or PCI Express bus, or any other bus structure whether synchronous or asynchronous. In addition to communicating over the communication bus 134, the management interface 120 may also provide separate signaling outputs 164. The separate signaling outputs 164 may provide more direct signaling to alert for any particular conditions determined by the time base manager 122. As examples, the signaling outputs 164 may be interrupt signals to the host controller, user interface signals that illuminate or activate a warning, error, or other status indicator (such as an LED, LCD segment, or audible alarm), or other types of signaling outputs.

The device 100 generally includes system logic 135 to implement whatever functionality the device 100 is meant to accomplish. The example shown in Figure 1 is geared toward a network switch, but the device 100 could be any type of device. In the context of an Ethernet network switch, for example, a time base may generate a frequency that clocks serialized data between communication interfaces. Accurate frequency and phase is desirable so that a receiver, using the same frequency, can recover the clocking information from the serialized data stream and accurately recover the data. In Figure 1, the system logic 135 is divided into a control plane 136, a data plane 138, subsidiary logic 140, and a local user interface 142. The control plane 136 may include one or more host controllers 144 in communication with memory and control logic 146. Just as one example, the memory 146 may store instructions executed by the host controller 144 to implement any desired functionality in the device 100.

The data plane 138 may include a clock distribution tree 148 for providing clock signals throughout the data plane, a switch fabric 150 for switching data packets, and data memory 152 for storing data packets and other data. The data plane 138 may also include a Physical (PHY) layer interface 154 that channels the data to one or more ports (e.g., the Ethernet ports 156 and 158). The PHY layer interface 154 may include Physical Medium Attachment (PMA), Physical Coding Sublayer (PCS), Physical Medium Dependent (PMD) sublayers, or an aspect of one of the aforementioned. Furthermore, the device 100 may include a Media Access Control (MAC) layer, Reconciliation Sublayer (RS) and other layers above and below the MAC, all of which may be driven be clocks ultimately arising from the time bases noted above. Besides an interface for a physical layer, the data plane may further include an interface for data link, network, transport, session, presentation, and application layers. One or more of the ports may connect the device 100 through a public or private network 160 to a remote analysis system 162. Accordingly, the device 100 may send or receive time base management data, instructions, and status to and from the remote analysis system 162.

The subsidiary logic 140 may control certain subsystems in the device 100. As examples, the subsidiary logic 140 may control fans, power supplies, or other systems. The subsidiary logic 140 may react to commands from the time base manager 122 or control plane 136 that result from time base management decisions. For example, the subsidiary logic may turn on fans or increase fan speed when the time base manager 122 determines that a time base needs to be kept cooler for correct operation or in anticipation of heavy load that will increase device temperature and that may jeopardize time base stability. As another example, the subsidiary logic 140 may adjust time base current or voltage or alter filtering of a time base signal when the control plane 136 determines that an operating condition, such as a high frequency interfering signal or low signal-to-noise ratio, needs correction or jeopardizes proper operation of the system logic 135.

The local user interface 142 may be any indicator, display, annunciator or other audio / visual interface. Accordingly, the device 100 may communicate time base status (e.g., early warning messages) to an operator using the local user interface 142.

The remote analysis system 162 may collect data from many different devices, profile the time bases of the devices, and make proactive management decisions that are communicated to the devices. The analysis results received from the remote analysis system 162 may then influence management of the time bases in the device 100. Also, the remote system may communicate analyzed results back to manufacturers, designers, foundries, or other engineering or management personnel. The different devices that offer data to the analysis system 162 may include any device described or illustrated in Figures 1-6, any node on the network 160, and any device that may be in communication with the remote analysis system 162. The data collected from the different devices may include time base operational and characteristic data, as well as analysis results local to a given device. For, example, the data collected may result from analysis of local time base characteristics, optionally with respect to established operational profiles of the time bases. The time base data collected may include any time base management data, such as instructions given to any time base, time base status information, configuration information or actions taken on a time base, operational characteristics over time, and other time base characteristic data.

With respect to the established operational profiles, the remote analysis system 162 may establish such profiles based on historical or real-time operational data or by receiving profile information from time bases or the device or time base manufacturers, designers, foundries, or other engineering or management personnel responsible for development of the time bases. Also, the established operational profiles may tune or customize the device at manufacturing time for any desired application of the device (e.g., by setting a particular profile for consumer applications versus a different version of the profile setup for high precision applications). The proactive management decisions that are communicated to the devices may be based on the time base data and the analysis results. As some examples, the proactive management decisions may include a decision to change time base current, voltage, or the like, selectively reconfigure a time base, or selectively shutdown or startup a time base or any of the logic in the device 100, including the TBML 102 or system logic 135. Further, the management decisions can include to change an operating profile of a time base (e.g., change a parameter of an operating profile, such as change a desired signal-to-noise ratio of an outputted clock signal) or to change system settings of one of the different devices. Also, the decision can include asserting an alert signal or sending an alert message.

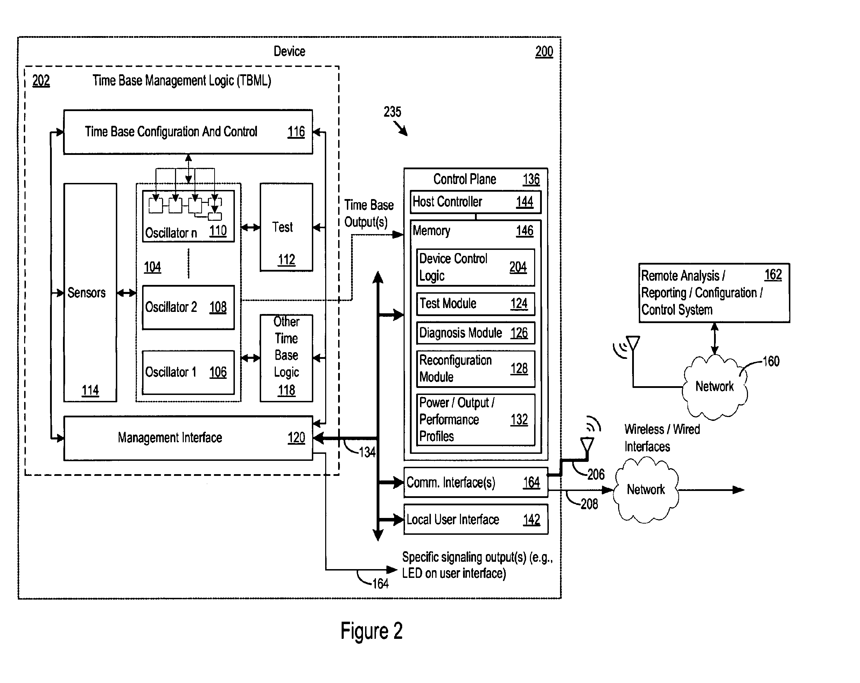

Figure 2 is another example implementation of a device 200 that includes time base management logic (TBML 202). In the example shown in Figure 2, the TBML 202 manages the set of time bases 104, any of which may provide one or more time references for any part of the device 200. The TBML 202 is in communication with the set of time bases 104. Four examples of the TBML 202 are shown in Figure 2: the test logic 112, the sensors 114, the time base configuration and control logic 116, and the other time base logic 118.

The TBML 202 also includes the management interface 120. The management interface 120 provides a signal connection interface between the management support logic and the system logic 235 of the device 200, as will be discussed further below. To that end, and as mentioned above, the management interface 120 may include buffers, amplifiers, line drivers, messaging interfaces or other analog or digital logic to communicate with the management support logic and the system logic 235.

The management interface 120 communicates with the system logic 235 over the communication bus 134. In addition to communicating over the communication bus 134, the management interface 120 may also provide separate signaling outputs 164 that may communicate through a network, such as the network 160, via wireless communication interface 206 or wired communication interface 208. As examples, the management interface 120 may be accessed through the network 160 via the Link Layer Discovery Protocol (LLDP), Simple Network Management Protocol (SNMP), or any other network protocol. The separate signaling outputs 164 may also provide a direct signaling connection to any of the system logic 235 to alert for any particular conditions determined by the system logic 235. As examples, the signaling outputs 164 may be interrupt signals to the host controller, user interface signals that illuminate or activate a warning, error, or other status indicator (such as an LED, LCD segment, or audible alarm), or other types of signaling outputs.

In general, the system logic 235 of device 200 implements whatever functionality the device 200 is meant to accomplish. The example shown in Figure 2 may be geared toward a smart phone, but the device 200 could be any type of device configured to communicate wirelessly, such as a wireless communications router. In contrast to the example shown in Figure 1, the device 200 includes the time base manager functionality in the control plane 136 of the device 200. For example, the time base manager functionality may be implemented in firmware in a firmware memory in the device 200 and may be executed by the host controller 144. In Figure 2, the system logic 235 is divided into the control plane 136, the signaling outputs 164, and the local user interface 142. The control plane 136 may include one or more host controllers 144 in communication with memory 146 and device control logic 204. Just as one example, the memory 146 may store instructions executed by the host controller 144 to implement any desired functionality in the device 200. As noted above, the memory 146 may also include the logic of the time base manager 122 of device 100 for exercising management control over the set of time bases 104 in cooperation with the TBML 202. Figure 2 shows several examples: the test module 124, the diagnosis module 126, and the reconfiguration model 128. The memory 146 may also include the management profiles 132, discussed further below.

Although not depicted in Figure 2, the device 200 may include a separate data plane and the subsidiary logic that may control certain subsystems in the device 200. The communication interface 164 may connect the device 200 through a public or private network, such as the network 160 to the remote analysis system 162. Accordingly, the device 200 may send or receive time base management data, instructions, and status to and from the remote analysis system 162 via the wireless communication interface 206 and the wired communication interface 208.

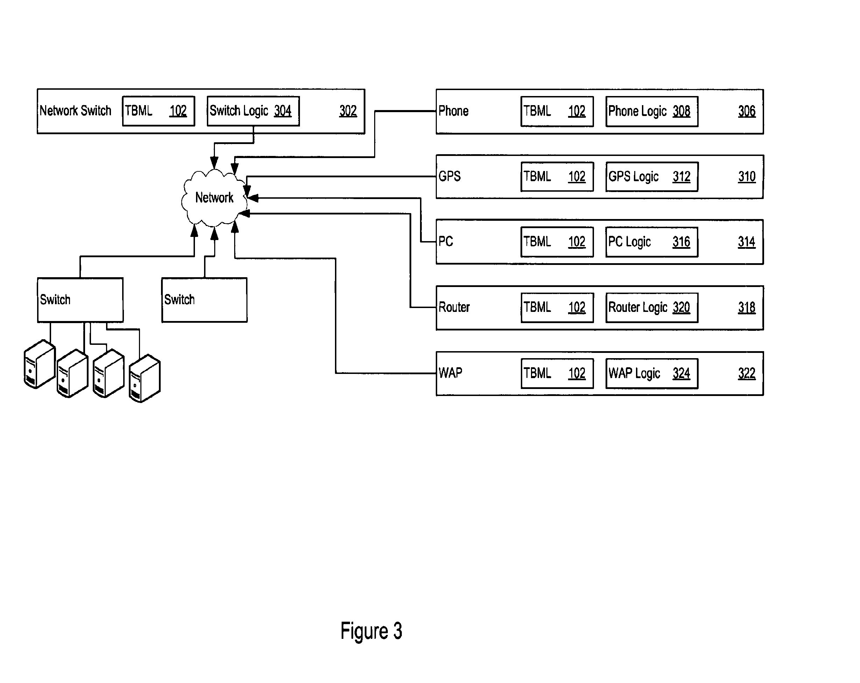

Figure 3 shows additional examples of devices that may include time base management logic. These examples include a network switch 302, a phone 306, a GPS 310, a personal computer (PC) 314, a router 318, and a wireless access point (WAP) 322. Each of these devices may include TBML (e.g., the TBML 102 or 202) and system logic. The system logic may include, for example, the control plane 136, the data plane 138, the subsidiary logic 140, the local user interface 142, and the separate signaling outputs 164. The system logic will vary depending on the desired functionality that the device accomplishes, and is not limited to the examples given in Figures 1 and 2.

Each of the above example devices may utilize time base management logic differently. For example, in a smart phone, time base management of clock frequency and precision may be particularly important. During its operation, for example, the system logic in the smart phone may schedule or otherwise anticipate a transition from a lower data communication rate mode, such as 3G connected mode, to a high data communication rate mode, such as a 4G / LTE connected mode. Upon becoming aware of such a transition, system logic of the phone may send a notification to a time base manager, which may then execute a reconfiguration module to reconfigure a time base to provide clock accuracy needed for the higher data rate mode. Then when the phone switches back to the lower data rate mode, the system logic may send an update to the time base manager, which can reconfigure the time base for less stringent operation. This clock control example can apply to any device or network of devices where data communication rates can be changed, such as any of the devices depicted in Figure 3 or a network of such devices.

With respect to communications networks, time base management can also regulate for consistent clocking and synchronization of data communications from node to node of a network. This may be especially relevant in large Ethernet networks that rely on time base stability in order to avoid communication errors. Similar to the smart phone example, but on a much larger scale, system logic for any device across an entire network may send notifications to over devices on the network, or to a global time base manager for the network in order to notify the network of changes in data communication rates and other operational conditions (e.g., processing loads, signal-to-noise ratios, and temperatures). These conditions may reflect operational conditions among a group of devices or at, in, or around a specific device. Upon receiving the notifications, the global time base manager or the network's control plane can run a reconfiguration module to reconfigure one or more time bases in any desired devices to maintain clock stability and accuracy for the entire network. In short, the notifications or early warnings allow for fine-tuning operation of time bases of a network, so that the time bases provide consistent output. In the context of an Ethernet network switch, for example, a time base may produce the frequency reference that drives serialized data between communication interfaces. When the receiver uses the same frequency, the receiver can recover clocking information from the serialized data stream. However, if frequency and phase drift (as examples) cause too much variation at the sender, then the receiver may not be able to recover the clocking information and correctly receive the data. The management techniques help provide early warning of potential problems with such time bases and thus greatly facilitate proactive correction to, and the reliable operation of, such devices.

Such time base management control is also applicable to military and industry applications that may depend on high data rates and highly reliable data transmissions. As suggested above, such time base management may be proactive oppose to reactive, so communications under time base management can be more reliable. Other examples of applications that may benefit from dependable, resilient, and/or reconfigurable time bases due to time base management may include Ethernet Over SDH (commonly known as Ethernet over SONET), audiovisual bridging (e.g., audiovisual bridging conforming to IEEE 802.1 and IEEE 1588), GPS navigation, and mission critical systems, such as emergency medical and military systems.

Furthermore, besides providing for resilient and reconfigurable time bases, time base management may also allow for certain flexibility with respect to operations and manufacturing of time bases. For example, because a time base's operation can be maintained through time base management, it may be possible to relax manufacturing tolerances of the time base, and reduce cost, for example. Even in mission critical applications, the manufacturing tolerances may become relaxed, in part because the time base management logic may help keep the time base within specified criteria during device operation.

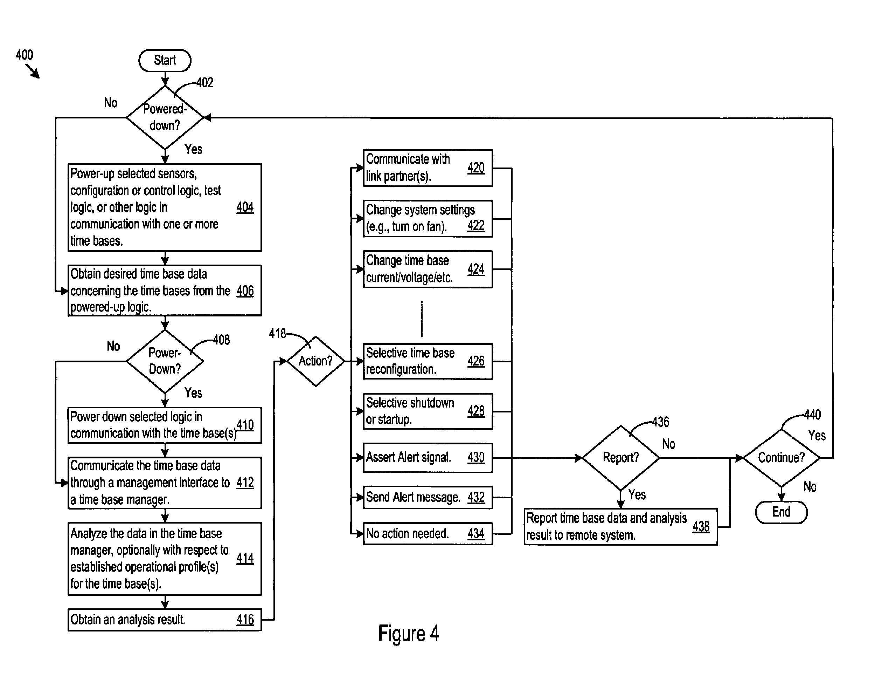

Figure 4 shows example logic 400 that may be implemented in hardware, software, firmware, or any combination thereof, to provide time base management. The logic 400 starts with determining whether selected sensors (e.g., the sensors 114), configuration or control logic (e.g., the time base configuration and control logic 116), test logic (e.g., the test logic 112), or other management support logic in communication with one or more time bases (e.g., the other time base logic 118), are powered-down (e.g., to save power) (402). If so, the logic 400 powers-up the selected sensors, the configuration or control logic, the test logic, or the other logic in communication with one or more time bases (404). The logic 400 obtains any desired time base data concerning the time bases from the powered-up management support logic (406), and may determines whether to power-down any of the management support logic (e.g., to save power) (408), and performs the power-down if desired (410).

The logic 400 may communicate the time base data through a management interface (e.g., the management interface 120) to a time base manager (e.g., the time base manager 122) (412). The logic 400 may analyzes the time base data (e.g., using in the time base manager), and the analysis may be done with respect to established operational profiles for the time bases (414). For example, the time base data may be compared to operational data in a currently active profile that characterizes proper time base operation. The logic 400 obtains an analysis result (e.g., a desired signal-to-noise ratio of an outputted clock signal) (416). Based on the analysis result the logic 400 selects a management action to take. Examples of management actions include: communicate time base status, warnings, or analysis results to link partners or other devices in communication with the device (420), change system settings (e.g., turn on fan, alter signal filtering, etc.) (422); change time base current, voltage, or the like (424); perform selective time base reconfiguration (426); or selectively shutdown or startup of a time base, the device containing the time base, one or more devices external to the device containing the time base (428). Additional examples of management actions include asserting an alert signal (e.g., asserting a local interrupt signal) (430) and sending an alert message (e.g., to a remote system) (432). In addition, the logic 400 need not take any action (e.g., in case the time base is functioning acceptably or within profile specifications) (434). Further, the logic 400 determines whether to report the time base data and the analysis result to a remote system (e.g., the remote analysis system 162) (438). The logic 400 may continue (440) as long as desired.

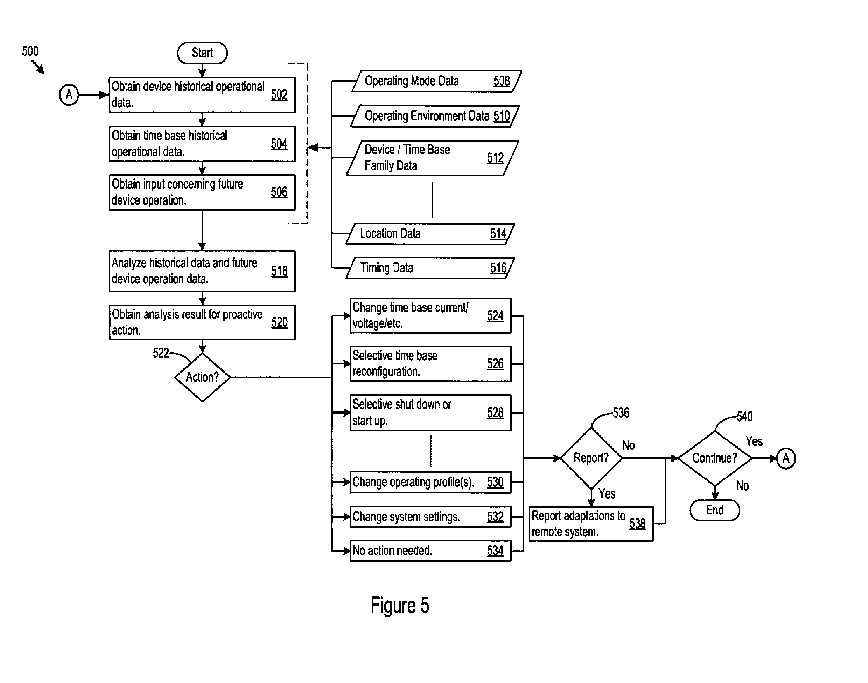

Figure 5 shows example logic 500 that may be implemented in hardware, software, firmware, or any combination thereof, for adapting operation of a time base, such as one of the times bases 104. The logic 500 obtains device historical operational data (502) and time base historical operational data (504). Further, the logic 500 obtains input regarding future device operation (or external device or network operation) (506). These inputs and data obtained at (502), (504), and (506) may include operating mode data 508 (e.g., whether the device is in 100Mb/s operation or 1 Gb/s operation), operating environment data 510 (e.g., temperature, humidity, vibration, or other environmental data internal or external to the device), device or time base family data 512 (e.g., characteristics of time bases made in the same fabrication run), location data 514 (e.g., the physical location of the device), and timing data 516 (timing data for when the device will switch from 100Mb/s operation to 1 Gb/s operation).

The logic 500 analyzes the device historical operational data, the time base historical operational data, and the input regarding future device operation (518). The logic 500 also obtains a result of the analysis, which may call for a proactive management action (520). Based on this analysis result, the logic 500 may select an action to take, such as: change time base current, voltage, frequency, phase, or the like (524); selective time base reconfiguration (526); or selective shutdown or startup of the device containing the time base, one or more device external to the device containing the time base (528). Further, the management action can include changing operating profiles (530), changing system settings (e.g., turn on fan, alter signal filtering, etc.) (532). Also, no action may be taken (534). In addition, the logic 500 determines whether to report time base data, analysis results, management actions, and/or adaptations to a remote system (e.g., the remote analysis system 162) (538). The logic 500 may continue this process (540) as long as desired.

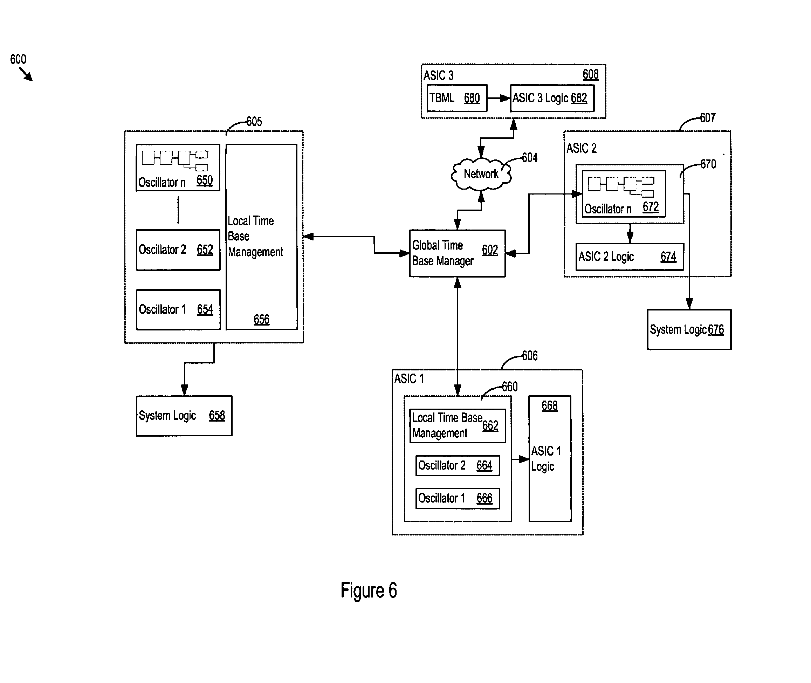

Figure 6 shows an example distributed architecture 600 for managing time bases, such as the time bases 650, 652, 654, 664, 666, and 672. The distributed architecture 600 provides a global time base manager 602 that may communicate directly or via a network 604 with remote or local TBML, such as the TBML 656, TBML 680, or TBML 662. The global time base manager 602 may also include its own time base management logic to directly control time bases in a system without such logic, such as the time base 672. The remote and local TBML may be present in any device, such as in the application-specific integrated circuits (e.g., ASIC 1 606, ASIC 2 607, or ASIC 3 608). As an example, the distributed architecture 600 may be a high performance computing system in which the ASIC 1 logic 668 may perform high definition graphics rendering, the ASIC 2 logic 674 may perform high performance general purpose computations for the system logic 676, the ASIC logic 658 may implement a high speed networking interface, and the ASIC 3 logic 682 may implement a remote high performance database server.

The global time base manager 602 may obtain any time base data from any of the distributed ASICs, and may centrally coordinate time base control. The ASICs may include any number of time bases of any implementation. For example, ASIC 1 606 includes the crystal oscillators 664 and 666, the ASIC 2 607 includes the silicon oscillator 672, and the ASIC 605 includes multiple silicon time bases, three of which are labeled 650, 652, and 654. Any of the distributed ASICs may include local time base management logic (e.g., the TBML 656, 680, and 662) that communicates with the global time base manager 602 and that may take instructions from the global time base manager 602.

As an example, the global time base manager 602 may execute any of the logic described above (e.g., with respect to Figures 4 and 5) to control the local TBML 656, 680, or 662 (or directly control the oscillator 672), and therefore control the local time bases in any manner desired (e.g., according to a selected system wide operating profile) for the distributed system 600 as a whole. For example, when the time base 672 is able to operate at a higher frequency, the global time base manager 602 may not only increase the frequency of the time base 672, but also of the graphics processing oscillators 664 or 666 to keep pace with rendering operations given the increased data throughput. The global time base manager 602 may also issue time base control actions to the TBML 656 to increase the clock speed of the oscillators 650, 652, or 654 to support 1GB/s data transfer instead of 100Mb/s transfer to receive data more quickly to keep the ASIC 2 logic 674 busy performing high performance general purpose computations for the system logic 676 at the increased clock speed.

In one aspect the time base management logic interfaces to a silicon time base (e.g., a silicon oscillator or a semiconductor replacement for a crystal oscillator) through a management interface, and manages the silicon time base through the management interface. Managing the time base may include reconfiguring the time base, executing a test of the time base, executing a test of the silicon time base, adapting the silicon time base according to a selected quality profile, adapting the silicon time base according to a selected energy consumption profile, adapting the silicon time base according to a selected oscillator output profile, and obtaining an operational characteristic of the silicon time base. Managing the time base may also include reporting the operational characteristic, where reporting may include communicating the operational characteristic through a communication interface to an external system. Managing the time base may also include analyzing the operational characteristic and taking a responsive action on the silicon time base, where taking the responsive action may include activating a backup time base or deactivating the silicon time base.

Reconfiguring the time base may include reconfiguring a first part of the silicon time base to facilitate a test on a second part of the silicon time base. The operational characteristic may include a voltage, current, temperature, or frequency characteristic of the time base, or any combination thereof.

The time base management logic may also receive a management instruction from the external system, and take a responsive action on the silicon time base according to the management instruction. Taking the responsive action may include activating a backup time base and deactivating the silicon time base, or any combination thereof. Taking the responsive action may also include adapting the silicon time base according to a specified quality profile, an energy consumption profile, a time base output profile, or any combination thereof.

In another aspect, the time base management logic may include a time base, a management interface in communication with the time base, and a time base manager configured to execute a management action on the time base through the time base management interface. The management action may include reconfiguring the time base, executing a test of the time base, adapting the time base to meet a selected quality profile, adapting the silicon time base to meet a selected energy consumption profile, adapting the time base to meet a selected oscillator output profile, reconfiguring a first part of the time base to facilitate a test on a second part of the time base, and obtaining an operational characteristic of the silicon time base. Also, the management action may include receiving a management instruction from an external system, and taking a responsive action on the time base according to the management instruction. The operational characteristic may include a voltage, current, temperature, or frequency characteristic of the time base, or any combination thereof.

As suggested above, TBML may be incorporated into any device. As examples, the devices may be cell phones, smart phones, laptop computers, personal data assistants, pocket computers, tablet computers, or portable email devices. Additional examples of devices include televisions, stereo equipment such as amplifiers, pre-amplifiers, and tuners, home media devices such as compact disc (CD) / digital versatile disc (DVD) players, portable MP3 players, high definition (e.g., Blu-Ray (TM) or DVD audio) media players, or home media servers. Other examples of devices include climate control systems, intrusion alarms, audio/video surveillance or security equipment, video games, network attached storage, and network routers and gateways. The devices may be found in virtually any context, including the home, business, public spaces, or automobile. Thus, as additional examples, devices may further include automobile audio head ends or DVD players, satellite music transceivers, noise cancellation systems, voice recognition systems, climate control systems, navigation systems, alarm systems, engine computer systems, or other devices.

The methods, devices, modules, and logic described above may be implemented in many different ways in many different combinations of hardware, software, firmware, or any combination thereof. For example, all or parts of the system may include circuitry in a controller, a microprocessor, or an ASIC, or may be implemented with discrete logic or components, or a combination of other types of analog or digital circuitry, combined on a single integrated circuit or distributed among multiple integrated circuits. All or part of the logic described above may be implemented as instructions for execution by a processor, controller, or other processing device and may be stored in a tangible or non-transitory machine-readable or computer-readable medium such as flash memory, random access memory (RAM) or read only memory (ROM), erasable programmable read only memory (EPROM) or other machine-readable medium such as a compact disc read only memory (CDROM), or magnetic or optical disk. Thus, a product, such as a computer program product, may include a storage medium and computer readable instructions stored on the medium, which when executed in an endpoint, computer system, or other device, cause the device to perform operations according to any of the description above.

The processing capability of the system may be distributed among multiple system components, such as among multiple processors and memories, optionally including multiple distributed processing systems. Parameters, databases, and other data structures may be separately stored and managed, may be incorporated into a single memory or database, may be logically and physically organized in many different ways, and may implemented in many ways, including data structures such as linked lists, hash tables, or implicit storage mechanisms. Programs may be parts (e.g., subroutines) of a single program, separate programs, distributed across several memories and processors, or implemented in many different ways, such as in a library, such as a shared library (e.g., a dynamic link library (DLL)). The DLL, for example, may store code that performs any of the system processing described above. While various embodiments of the invention have been described, it will be apparent to those of ordinary skill in the art that many more embodiments and implementations are possible within the scope of the invention. Accordingly, the invention is not to be restricted except in light of the attached claims and their equivalents.

## Claims

1. A method, comprising:
interfacing to a silicon time base through a management interface; and
managing the silicon time base through the management interface.

2. The method of claim 1, where managing comprises:
reconfiguring the silicon time base.

3. The method of claim 1 or 2, where managing comprises:
executing a test of the silicon time base.

4. The method of any preceding claim, where managing comprises:
adapting the silicon time base according to a selected quality profile.

5. The method of any preceding claim, where managing comprises:
adapting the silicon time base according to a selected energy consumption profile.

6. The method of any preceding claim, where managing comprises:
adapting the silicon time base according to a selected oscillator output profile.

7. The method of any of the claims 2 to 6, where reconfiguring comprises:
reconfiguring a first part of the silicon time base to facilitate a test on a second part of the silicon time base.

8. The method of any preceding claim, where managing comprises:
obtaining an operational characteristic of the silicon time base.

9. The method of claim 8, where the operational characteristic comprises a voltage, current, or temperature characteristic of the time base, or any combination thereof.

10. The method of claim 8, where the operational characteristic comprises a frequency characteristic of the time base.

11. A system comprising:
a time base;
a management interface in communication with the time base; and
a time base manager configured to execute a management action on the time base through the time base management interface.

12. The system of claim 11 where the management action comprises:
reconfiguring the time base.

13. The system of claim 11 or 12 where the management action comprises:
executing a test of the time base.

14. The system of any of the claims 11 to 13 where the management action comprises:
adapting the time base to meet a selected quality profile.

15. The system of any of the claims 11 to 14 where the management action comprises:
adapting the silicon time base to meet a selected energy consumption profile.
